# EUROPÄISCHE PATENTSCHRIFT

(11) **EP 3 870 982 B1**
(45) Veröffentlichungstag und Bekanntmachung des Hinweises auf die Patenterteilung: **12.03.2025**
(21) Anmeldenummer: 19797181.5
(22) Anmeldetag: 17.10.2019
(51) Int. Cl.: G01R 27/02, G01R 31/42

(54) **VERFAHREN ZUR ISOLATIONSWIDERSTANDSMESSUNG IN WECHSELRICHTERN MIT MEHRPUNKTTOPOLOGIE UND WECHSELRICHTER MIT MEHRPUNKTTOPOLOGIE**
METHOD FOR MEASURING INSULATION RESISTANCE IN INVERTERS WITH MULTIPOINT TOPOLOGY, AND INVERTER WITH MULTIPOINT TOPOLOGY
PROCÉDÉ DE MESURE DE LA RÉSISTANCE D'ISOLEMENT DANS LES ONDULEURS À TOPOLOGIE MULTIPOINT ET LES ONDULEURS À TOPOLOGIE MULTIPOINT

(30) Priorität: 22.10.2018 DE 102018126235
(43) Veröffentlichungstag der Anmeldung: 01.09.2021
(73) Patentinhaber: SMA Solar Technology AG, 34266 Niestetal (DE)
(72) Erfinder: AUST, Steffen, 34266 Niestetal (DE); PUTZ, Martin, 34119 Kassel (DE)
(86) Internationale Anmeldenummer: PCT/EP2019/078165
(87) Internationale Veröffentlichungsnummer: WO 2020/083734

(56) Entgegenhaltungen:
- WO-A1-2013/178654
- US-A1- 2017 302 082

## Beschreibung

### TECHNISCHES GEBIET DER ERFINDUNG

Die Erfindung bezieht sich auf ein Verfahren zur Isolationswiderstandsmessung in einem Wechselrichter und auf einen Wechselrichter zur Durchführung eines solchen Verfahrens. Insbesondere bezieht sich die Erfindung auf ein Verfahren mit den Merkmalen des Oberbegriffs des unabhängigen Patentanspruchs 1 und auf einen Wechselrichter mit den Merkmalen des Oberbegriffs des unabhängigen Patentanspruchs 9.

Bei der Isolationswiderstandsmessung in dem Wechselrichter geht es nicht nur um den Isolationswiderstand des Wechselrichters selbst, sondern auch um den Isolationswiderstand eines an einen eingangsseitigen Gleichspannungszwischenkreis angeschlossenen Generators, insbesondere eines Photovoltaikgenerators.

### STAND DER TECHNIK

Aus der WO 2013/178654 A1 sind ein Verfahren zur Messung eines Isolationswiderstands und ein Wechselrichter mit einer Vorrichtung zum Messen eines Isolationswiderstands bekannt, die die Merkmale des Oberbegriffs des Patentanspruchs 1 und des Oberbegriffs des Patentanspruchs 8 aufweisen. Bei dem bekannten Verfahren und dem bekannten Wechselrichter wird ein zwischen Schaltelementen einer Halbbrücke des Wechselrichters liegender Brückenmittelpunkt durch Schließen eines Erdschalters mit einem Erdungspunkt verbunden. Der mit dem Erdungspunkt verbundene Brückenmittelpunkt wird mittels der Schaltelemente der Halbbrücke nacheinander mit den beiden ungeerdeten Polen einer an der Halbbrücke anliegenden Zwischenkreisspannung des Wechselrichters verbunden, und der über diese Verbindung zu dem Erdungspunkt fließende Strom wird gemessen. Auf diese Weise werden die Spannungen der Pole der Zwischenkreisspannung gegenüber Erde als Prüfspannungen für die Messung des Isolationswiderstands verwendet und über die Schaltelemente der Halbbrücke zugeschaltet.

Ein Verfahren mit den Merkmalen des Oberbegriffs des Patentanspruchs 1 und eine Vorrichtung mit den Merkmalen des Oberbegriffs des unabhängigen Patentanspruchs 9 sind auch aus der US 2012/0026631 A1 bekannt. Hier wird der über die Verbindung zu dem Erdungspunkt fließende Strom mit einem Stromsensor gemessen. Zusätzlich werden die Potentiale der ungeerdeten Pole der Zwischenkreisspannung gemessen.

Während die Schaltelemente im normalen Betrieb des aus der WO 2013/178654 A1 bekannten Wechselrichters nur mit der Hälfte der Zwischenkreisspannung belastet werden, kann diese Belastung bei der Durchführung des aus der WO 2013/178654 A1 bekannten Verfahrens zur Messung des Isolationswiderstands bis auf die Zwischenkreisspannung ansteigen, auch wenn keiner der beiden Pole der Zwischenkreisspannung geerdet ist. Damit besteht bei Zwischenkreisspannungen, die größer als eine nominelle Spannungsfestigkeit der Schaltelemente der Brückenschaltung und insbesondere von Hardware-Komponenten der Messschaltung ist, die Gefahr, dass dieser Spannungsgrenzwert bei der Messung des Isolationswiderstands überschritten wird.

Für Wechselrichter mit höheren Leistungen und insbesondere mit höheren Zwischenkreisspannungen in einem Gleichspannungszwischenkreis sind Brückenschaltungen mit Mehrpunkttopologie bekannt, beispielsweise in sogenannten 3-Level-Invertern. Durch eine Brückenschaltung mit Mehrpunkttopologie können beispielsweise Schaltungsverluste bei hohen über den Schaltelementen anliegenden Spannungen verringert werden. Bei einem 3-Level-Inverter verbindet die Brückenschaltung ihren Brückenmittelpunkt nicht nur wechselweise mit den beiden Endpunkten des Gleichspannungszwischenkreises, zwischen denen die Zwischenkreisspannung anliegt, sondern auch mit einem Spannungsmittelpunkt des Gleichspannungszwischenkreises, der mit Hilfe eines geteilten Zwischenkreises bereitgestellt wird.

Praktisch werden 3-Level-Inverter zum Beispiel in Photovoltaikanlagen eingesetzt, deren Photovoltaikgeneratoren die Gleichspannungszwischenkreise der Wechselrichter auf bis zu 1.500 V aufladen, wobei in der Brückenschaltung Schaltelemente mit einer nominellen Spannungsfestigkeit von beispielsweise 1000 V zum Einsatz kommen.

WO 2013/178654 A1 offenbart ein Verfahren zur Messung des Isolationswiderstands für einen Wechselrichter.

### AUFGABE DER ERFINDUNG

Der Erfindung liegt die Aufgabe zugrunde, ein Verfahren mit den Merkmalen des Oberbegriffs des unabhängigen Patentanspruchs 1 und einen entsprechenden Wechselrichter mit den Merkmalen des Oberbegriffs des unabhängigen Patentanspruchs 9 bereitzustellen, die eine sichere Isolationswiderstandsmessung auch dann erlauben, wenn der Gleichspannungszwischenkreis auf eine Zwischenkreisspannung aufgeladen ist, die eine nominelle Spannungsfestigkeit von Schaltelementen seiner Brückenschaltung und insbesondere von Hardware-Komponenten der Messschaltung deutlich überschreitet, so dass auch die Spannung eines der Endpunkte des ungeerdeten Gleichspannungszwischenkreises gegenüber Erde diesen Spannungsgrenzwert überschreiten kann.

### LÖSUNG

Die Aufgabe der Erfindung wird durch ein Verfahren zur Isolationswiderstandsmessung mit den Merkmalen des unabhängigen Patentanspruchs 1 und durch einen Wechselrichter mit den Merkmalen des unabhängigen Patentanspruchs 9 gelöst. Bevorzugte Ausführungsformen des erfindungsgemäßen Verfahrens und des erfindungsgemäßen Wechselrichters sind in den abhängigen Patentansprüchen definiert.

### BESCHREIBUNG DER ERFINDUNG

Bei einem Verfahren zur Isolationswiderstandsmessung in einem Wechselrichter, der einen Gleichspannungszwischenkreis und eine an den Gleichspannungszwischenkreis angeschlossene Brückenschaltung zum Treiben eines Wechselstroms über einen Brückenmittelpunkt aufweist, das die Schritte Verbinden des Brückenmittelpunkts mit einem Erdungspunkt, Verbinden des mit dem Erdungspunkt verbundenen Brückenmittelpunkts mittels der Brückenschaltung nacheinander mit zwei spannungsverschiedenen Punkten des ungeerdeten Gleichspannungszwischenkreises und Messen der von den beiden spannungsverschiedenen Punkten zu den Erdungspunkten fließenden Ströme umfasst, werden die beiden spannungsverschiedenen Punkte des ungeerdeten Gleichspannungszwischenkreises aus einer Gruppe von Punkten, die neben den beiden Endpunkten des Gleichspannungszwischenkreises mindestens einen Zwischenspannungspunkt des Gleichspannungszwischenkreises umfasst, so ausgewählt, dass die zwischen den beiden spannungsverschiedenen Punkten und Erde anliegenden elektrischen Spannungen einen vorgegebenen Spannungsgrenzwert nicht überschreiten.

Die elektrischen Potentiale der beiden Endpunkte des Gleichspannungszwischenkreises entsprechen den elektrischen Potentialen seiner beiden Pole zwischen denen der Gleichspannungszwischenkreis auf eine Zwischenkreisspannung aufgeladen wird. Der Zwischenspannungspunkt weist ein elektrisches Potential zwischen den elektrischen Potentialen der beiden Pole des Gleichspannungszwischenkreises und damit auch eine elektrische Spannung gegenüber Erde auf, die zwischen den Spannungen der beiden Endpunkte des Gleichspannungszwischenkreises gegenüber Erde liegt.

Durch die Auswahl der beiden spannungsverschiedenen Punkte für die Isolationswiderstandsmessung aus der Gruppe von Punkten, die zusätzlich den Zwischenspannungspunkt des Gleichspannungszwischenkreises umfasst, wird dann, wenn die Zwischenkreisspannung den vorgegebenen Spannungsgrenzwert überschreitet und damit die Gefahr besteht, dass einer der beiden Endpunkte des Gleichspannungszwischenkreises eine Spannung gegenüber Erde aufweist, die ebenfalls den Spannungsgrenzwert überschreitet, die Möglichkeit geschaffen, eine Belastung von Schaltelementen der Brückenschaltung und insbesondere von Hardware-Komponenten der Messschaltung bei der Isolationswiderstandsmessung mit Spannungen oberhalb des Spannungsgrenzwerts zu vermeiden. So können die Hardware-Komponenten der Messschaltung für eine kleinere Spannungs- und Leistungsbelastung ausgelegt werden, als sie die maximale Systemspannung des Wechselrichters gegenüber Erde hervorrufen würde. Damit können bei den Hardware-Komponenten der Messschaltung zum Beispiel Kosteneinsparungen, Robustheitsvorteile, eine geringere Verlustleistung und ein reduzierter Platzbedarf realisiert werden.

Das erfindungsgemäße Verfahren kann also in jedem Wechselrichter, dessen Brückenschaltung den Brückenmittelpunkt neben den beiden Endpunkten des Gleichspannungszwischenkreises auch mit mindestens einem Zwischenspannungspunkt des Gleichspannungszwischenkreises verbinden kann, durchgeführt werden. Dies ist bei Wechselrichtern mit Mehrpunkttopologie, insbesondere sogenannten 3-Level-Invertern, wie sie sowieso häufig bei hohen Zwischenkreisspannungen zum Einsatz kommen, der Fall. Messvorrichtungen zum Erfassen der elektrischen Spannungen aller spannungsverschiedenen Punkte aus der Gruppe der möglichen spannungsverschiedenen Punkte gegenüber Erde sind bei vielen Wechselrichtern ebenfalls vorhanden oder können mit geringem Aufwand nachgerüstet werden.

Beim Auswählen der beiden spannungsverschiedenen Punkte des ungeerdeten Gleichspannungszwischenkreises aus der auch mindestens einen Zwischenspannungspunkt des Gleichspannungszwischenkreises umfassenden Gruppe von Punkten kann geprüft werden, ob eine der beiden zwischen den beiden Endpunkten des Gleichspannungszwischenkreises und Erde anliegenden Spannungen den vorgegebenen Spannungsgrenzwert überschreitet. Falls dies nicht der Fall ist, werden die beiden Endpunkte des Gleichspannungszwischenkreises für die Isolationswiderstandsmessung ausgewählt. Wenn jedoch einer der beiden Endpunkte mit seiner Spannung gegenüber Erde den Spannungsgrenzwert überschreitet, werden der andere Endpunkt des Gleichspannungszwischenkreises, bei dem die Spannung gegenüber Erde den vorgegebenen Spannungsgrenzwert nicht überschreitet, und der Zwischenspannungspunkt des Gleichspannungszwischenkreises als die beiden spannungsverschiedenen Punkte ausgewählt.

Konkret kann das Auswählen der beiden spannungsverschiedenen Punkte des ungeerdeten Gleichspannungszwischenkreises so implementiert werden, dass in einer ersten Prüfung geprüft wird, ob die zwischen einem ersten der beiden Endpunkte des Gleichspannungszwischenkreises und Erde anliegende Spannung den vorgegebenen Spannungsgrenzwert überschreitet, und in einer zweiten Prüfung, ob die zwischen dem zweiten der beiden Endpunkte des Gleichspannungszwischenkreises und Erde anliegende Spannung den vorgegebenen Spannungsgrenzwert überschreitet. Dann kann basierend auf einem ersten Ergebnis der ersten Prüfung und einem zweiten Ergebnis der zweiten Prüfung mit Hilfe einer Wahrheitstabelle festgelegt werden, welche beiden spannungsverschiedenen Punkte des ungeerdeten Gleichspannungszwischenkreises aus der Gruppe von Punkten ausgewählt werden. Diese Wahrheitstabelle kann wie folgt aussehen:

| Prüfergebnisse | | Resultierende Auswahl | | |
|---|---|---|---|---|
| Spannung 1. Endpunkt zu PE > Grenzwert | Spannung 2. Endpunkt zu PE > Grenzwert | 1. Endpunkt | 2. Endpunkt | Zwischenspannungspunkt |
| Nein | Nein | Ja | Ja | Nein |
| Ja | Nein | Nein | Ja | Ja |
| Nein | Ja | Ja | Nein | Ja |

In der voranstehenden Wahrheitstabelle führt der Eintrag in der ersten Zeile, d. h. die Auswahl des ersten und des zweiten Endpunkts als die beiden spannungsverschiedenen Punkte, falls beide Spannungen des ersten und des zweiten Endpunkts gegenüber Erde den vorgegebenen Spannungsgrenzwert nicht überschreiten, zu einem maximalen Unterschied zwischen den beiden Spannungen, die den zu dem Erdungspunkt fließenden Strom treiben, was für die genaue Messung des Isolationswiderstands günstig ist. Zulässig wäre aber auch die Auswahl eines der beiden Endpunkte und des Zwischenspannungspunkts als die beiden spannungsverschiedenen Punkte des ungeerdeten Gleichspannungszwischenkreises.

Alternativ kann das Auswählen der beiden spannungsverschiedenen Punkte des ungeerdeten Gleichspannungszwischenkreises so implementiert werden, dass in einem ersten Teilschritt geprüft wird, ob eine zwischen den beiden Endpunkten des Gleichspannungszwischenkreises anliegende Zwischenkreisspannung den vorgegebenen Spannungsgrenzwert tatsächlich überschreitet. Wenn dies nicht der Fall ist, kann in der Regel davon ausgegangen werden, dass auch die beiden Spannungen zwischen den beiden Endpunkten des Gleichspannungszwischenkreises und Erde den Grenzwert nicht überschreiten, weil die beiden Spannungen zwischen den beiden Endpunkten des Gleichspannungszwischenkreises und Erde bei einem ungeerdeten Gleichspannungszwischenkreis zwar nicht gleich groß sein müssen und auch nicht gleich groß sein werden, aber in der Regel kein gleiches Vorzeichen aufweisen. Entsprechend können die beiden Endpunkte des Gleichspannungszwischenkreises als die beiden spannungsverschiedenen Punkte ausgewählt werden.

In einem zweiten Teilschritt des Auswählens der beiden spannungsverschiedenen Punkte, der nur dann durchgeführt wird, wenn die Zwischenkreisspannung den vorgegebenen Spannungsgrenzwert überschreitet, kann dann überprüft werden, ob die zwischen einem ersten der beiden Endpunkte des Gleichspannungszwischenkreises, d. h. zwischen einem ersten der beiden Pole des Gleichspannungszwischenkreises, und Erde anliegende Spannung den vorliegenden Grenzwert überschreitet. Wenn dies der Fall ist, werden der zweite der beiden Endpunkte und der Zwischenspannungspunkt des Gleichspannungszwischenkreises als die beiden spannungsverschiedenen Punkte des ungeerdeten Gleichspannungszwischenkreises ausgewählt, weil davon ausgegangen werden kann, dass die beiden Spannungen dieser beiden spannungsverschiedenen Punkte gegenüber Erde den Spannungsgrenzwert nicht überschreiten, soweit der Zwischenspannungspunkt ein Spannungsmittelpunkt des Gleichspannungszwischenkreises ist, soweit sich die Zwischenkreisspannung im zulässigen Rahmen von weniger als dem Doppelten des Spannungsgrenzwerts bewegt und soweit die Regel gilt, dass die beiden Spannungen zwischen den beiden Endpunkten des Gleichspannungszwischenkreises und Erde kein gleiches Vorzeichen aufweisen.

In einem dritten Teilschritt des Auswählens der beiden spannungsverschiedenen Punkte, der nur durchgeführt wird, wenn die zwischen dem ersten der beiden Endpunkte des Gleichspannungszwischenkreises und Erde anliegende Spannung den vorgegebenen Spannungsgrenzwert nicht überschreitet, kann überprüft werden, ob die zwischen dem zweiten der beiden Endpunkte des Gleichspannungszwischenkreises und Erde anliegende Spannung den Spannungsgrenzwert überschreitet. Wenn dies nicht der Fall ist, können die beiden Endpunkte des Gleichspannungszwischenkreises als die beiden spannungsverschiedenen Punkte des ungeerdeten Gleichspannungszwischenkreises ausgewählt werden, obwohl die zwischen ihnen anliegende Zwischenkreisspannung den Spannungsgrenzwert überschreitet. Anderenfalls werden der erste der beiden Endpunkte und der Zwischenspannungspunkt des Gleichspannungszwischenkreises ausgewählt, weil an diesen keine den Spannungsgrenzwert überschreitende Spannung gegenüber Erde anliegt. Zumindest gilt dies, wenn der Zwischenspannungspunkt ein Spannungsmittelpunkt des Gleichspannungszwischenkreises ist und die Zwischenkreisspannung im zulässigen Rahmen von weniger als dem Doppelten des Spannungsgrenzwerts bleibt. Der verfügbare Zwischenspannungspunkt des Gleichspannungszwischenkreises wird aufgrund der Topologie des Wechselrichters sowieso in aller Regel der Spannungsmittelpunkt des Gleichspannungszwischenkreises sein.

Es versteht sich, dass für jede der vorgenannten Prüfungen, ob eine Spannung den vorgegebenen Spannungsgrenzwert überschreitet, die jeweilige Spannung nicht direkt gemessen werden muss, sondern auch aus anderen gemessenen Werten abgeleitet werden kann, beispielsweise aus anderen gemessenen Spannungen, die mit der jeweils interessierenden Spannung über einen Spannungsumlauf verknüpft sind. So lässt sich aus der Spannung zwischen dem ersten der beiden Endpunkte des Gleichspannungszwischenkreises und Erde einerseits und der Zwischenkreisspannung andererseits durch Differenzbildung die Spannung zwischen dem zweiten der beiden Endpunkte des Gleichspannungszwischenkreises und Erde bestimmen.

Konkret kann der vorgegebene Spannungsgrenzwert zwischen 800 und 1.500 V oder zwischen 900 und 1.200 V, d. h. bei 1.000 V liegen.

Das erfindungsgemäße Verfahren kann neben seinen hier beschriebenen Besonderheiten bezüglich der Auswahl der spannungsverschiedenen Punkte des ungeerdeten Gleichspannungszwischenkreises hinsichtlich aller Details so ausgeführt werden, wie dies aus der WO 2013/178654 A1 bekannt ist.

Insbesondere wird der Brückenmittelpunkt beim Messen der zu dem Erdungspunkt fließenden Ströme regelmäßig von einem im normalen Betrieb des Wechselrichters, d. h. beim Treiben des Wechselstroms über den Brückenmittelpunkt, angeschlossenen Wechselstromnetz getrennt werden.

Der jeweils zu dem Erdungspunkt fließende Strom kann über einen Spannungsabfall an einem Messwiderstand gemessen werden, der zwischen den Brückenmittelpunkt und den Erdungspunkt geschaltet ist. Insbesondere kann der Spannungsabfall über dem Messwiderstand mit einer Messeinrichtung des Wechselrichters gemessen werden, die im normalen Betrieb des Wechselrichters einen Spannungsabfall über einen niederohmigeren Messwiderstand misst, um den Wechselstrom zu messen.

Die Schaltelemente der Brückenschaltung können nacheinander geschlossen werden, um nacheinander zwei Gleichströme von den beiden spannungsverschiedenen Punkten des Gleichspannungszwischenkreises zu dem Erdungspunkt fließen zu lassen. Aus den Stromstärken der beiden Gleichströme und den zugehörigen Spannungen der spannungsverschiedenen Punkte gegenüber Erde lässt sich der Isolationswiderstand in bekannter Weise berechnen.

Alternativ können die Schaltelemente der Brückenschaltung angesteuert werden, um von den beiden spannungsverschiedenen Punkten einen niederfrequenten Wechselstrom durch eine Netzdrossel des Wechselrichters zu dem Erdungspunkt fließen zu lassen. Dieser niederfrequente Wechselstrom hat dann eine um mindestens einen Faktor 2, vorzugsweise mindestens einen Faktor 5, mehr bevorzugt um mindestens einen Faktor 10, noch mehr bevorzugt um mindestens einen Faktor 50 und am meisten bevorzugt um mindestens einen Faktor 100 längere Periodendauer als der im Normalbetrieb des Wechselrichters fließende Wechselstrom.

Die Schaltelemente der Brückenschaltung können auch angesteuert werden, um an einem Filterausgang eines dem Brückenmittelpunkt nachgeschalteten Filters mindestens eine treibende Spannung für den durch eine Netzdrossel des Wechselrichters zu dem Erdungspunkt fließenden Strom einzustellen, die zwischen den Spannungen der beiden spannungsverschiedenen Punkte des Gleichspannungszwischenkreises gegenüber Erde liegt.

Die den jeweiligen Strom zu dem Erdungspunkt treibende Spannung kann mit Messeinrichtungen gemessen werden, mit denen beim Auswählen der beiden spannungsverschiedenen Punkte des ungeerdeten Gleichspannungszwischenkreises die zwischen ihnen und Erde anliegenden elektrischen Spannungen gemessen werden. Weiterhin kann zum Messen des jeweils zu dem Erdungspunkt fließenden Stroms eine Spannung bestimmt werden, die zwischen einem Punkt, der zwischen einem Schutzwiderstand und dem Erdungspunkt liegt, und einem der spannungsverschiedenen Punkte des ungeerdeten Gleichspannungszwischenkreises anliegt. Konkret kann die Spannung dieses Punktes gegenüber dem Spannungsmittelpunkt des Gleichspannungszwischenkreises gemessen werden.

Bei einem erfindungsgemäßen Wechselrichter mit einem Gleichspannungszwischenkreis, mit einer an den Gleichspannungszwischenkreis angeschlossenen Brückenschaltung zum Treiben eines Wechselstroms über einen Brückenmittelpunkt und einer Vorrichtung zum Messen eines Isolationswiderstands, die einen Erdschalter aufweist, mit welchem der Brückenmittelpunkt mit einem Erdungspunkt verbindbar ist, und die dazu ausgebildet ist, den mit dem Erdungspunkt verbundenen Brückenmittelpunkt mittels der Brückenschaltung nacheinander mit zwei verschiedenen Punkten des ungeerdeten Gleichspannungszwischenkreises zu verbinden und den von den beiden spannungsverschiedenen Punkten zu dem Erdungspunkt fließenden Strom zu messen, ist die Brückenschaltung eine Mehrpunktschaltung, die dazu ausgebildet ist, den Brückenmittelpunkt beim Treiben des Wechselstroms neben den beiden Endpunkten des Gleichspannungszwischenkreises, zwischen denen die Zwischenkreisspannung anliegt, auch mit mindestens einem Zwischenspannungspunkt des Gleichspannungszwischenkreises zu verbinden, und die Vorrichtung zum Messen des Isolationswiderstands ist zur Durchführung des erfindungsgemäßen Verfahrens ausgebildet.

Der erfindungsgemäße Wechselrichter ist demnach ein solcher mit einer Mehrpunkttopologie. Insbesondere kann es sich um einen 3-Level-Inverter handeln. Dann ist die Brückenschaltung eine Dreipunktschaltung, die dazu ausgebildet ist, den Brückenmittelpunkt beim Treiben des Wechselstroms neben den beiden Endpunkten auch mit einem Spannungsmittelpunkt als dem mindestens einen Zwischenspannungspunkt des Gleichspannungszwischenkreises zu verbinden.

Eine nominelle Spannungsfestigkeit von Schaltelementen der Brückenschaltung und/oder von Bestandteilen der Vorrichtung, die speziell zum Messen des Isolationswiderstands vorgesehen sind, kann bei dem erfindungsgemäßen Wechselrichter gleich dem vorgegebenen Spannungsgrenzwert sein. Die maximale Zwischenkreisspannung, auf die der Gleichspannungszwischenkreis im Betrieb des Wechselrichters aufgeladen wird, kann hingegen den Spannungsgrenzwert deutlich überschreiten, zum Beispiel um 50 %.

Auch bei dem erfindungsgemäßen Wechselrichter verhält es sich so, dass er bezüglich seiner Detailausgestaltung alle Merkmale und Merkmalskombinationen aufweisen kann, wie sie in der WO 2013/178654 A1 offenbart sind. So kann die Vorrichtung speziell dazu ausgebildet sein, einen Netzschalter des Wechselrichters zu öffnen, um den Brückenmittelpunkt zum Messen des zu dem Erdungspunkt fließenden Stroms von einem im normalen Betrieb des Wechselrichters angeschlossenen Wechselstromnetz zu trennen.

Weiter kann die Vorrichtung einen zwischen dem Brückenmittelpunkt und dem Erdungspunkt angeordneten Messwiderstand aufweisen und dazu ausgebildet sein, den zu dem Erdungspunkt fließenden Strom als Spannungsabfall über diesem Messwiderstand zu messen. Der Messwiderstand kann mit dem Erdschalter und einem Schutzwiderstand zur Vermeidung hoher Erdströme zwischen dem Brückenmittelpunkt und dem Erdungspunkt in Reihe geschaltet sein.

Eine Verbindung des Brückenmittelpunkts zu dem Erdungspunkt kann von einem Strompfad abzweigen, über den im normalen Betrieb des Wechselrichters der Wechselstrom fließt, wobei Messeinrichtungen des Wechselrichters, die im normalen Betrieb des Wechselrichters einen Spannungsabfall über einem weiteren Messwiderstand messen, der niederohmiger ist als der Messwiderstand für den zu dem Erdungspunkt fließenden Strom, über den Messwiderstand und den weiteren Messwiderstand hinweg angeschlossen sein können, so dass sie sowohl zum Messen des Wechselstroms als auch des Stroms zu dem Erdungspunkt verwendet werden können.

Die Vorrichtung kann auch ausgebildet sein, den Erdungspunkt mit einem Filterausgang eines dem Brückenmittelpunkt nachgeschalteten Filters zu verbinden.

Die Vorrichtung kann zusätzliche Messeinrichtungen aufweisen, um eine den jeweiligen Strom zu dem Erdungspunkt treibende Spannung zu messen. Diese Messeinrichtungen können zugleich für die Auswahl der beiden spannungsverschiedenen Punkte des Gleichspannungszwischenkreises gemäß dem erfindungsgemäßen Verfahren verwendet werden.

Dem Messwiderstand für das Messen des zu dem Erdungspunkt fließenden Stroms kann ein Filterkondensator parallelgeschaltet sein.

Messeinrichtungen zum Messen des jeweils zu dem Erdungspunkt fließenden Stroms können dazu ausgebildet sein, eine Spannung zu messen, die zwischen einem Punkt, der zwischen einem Schutzwiderstand und dem Erdungspunkt liegt, und einem der spannungsverschiedenen Punkte des ungeerdeten Gleichspannungszwischenkreises anliegt. Der jeweilige Punkt kann zwischen dem Schutzwiderstand und dem Erdschalter liegen, wobei der Schutzwiderstand zwischen dem Erdschalter und dem Erdungspunkt liegen kann. Der eine der spannungsverschiedenen Punkte des ungeerdeten Gleichspannungszwischenkreises, demgegenüber die Spannung gemessen wird, kann der Spannungsmittelpunkt des Gleichspannungszwischenkreises sein.

Weiterhin kann an einem Filterausgang zwischen einer Netzdrossel des Wechselrichters und dem Schutzwiderstand ein Filterkondensator zwischen die Verbindung zu dem Erdungspunkt und einen der spannungsverschiedenen Punkte des ungeerdeten Gleichspannungszwischenkreises geschaltet sein. Auch dieser spannungsverschiedene Punkt kann der Spannungsmittelpunkt des ungeerdeten Gleichspannungszwischenkreises sein.

Die Erfindung ist so, wie sie in den Ansprüchen definiert ist. Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere der relativen Anordnung und Wirkverbindung von Bauteilen - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Schaltelement die Rede ist, ist dies so zu verstehen, dass genau ein Schaltelement, zwei Schaltelemente oder mehr Schaltelemente vorhanden sind. Die in den Patentansprüchen angeführten Merkmale können durch andere Merkmale ergänzt werden oder die einzigen Merkmale sein, die das jeweilige Verfahren oder Erzeugnis aufweist. Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: ist ein Prinzipschaltbild zu einem erfindungsgemäßen Wechselrichter mit an seinen eingangsseitigen Gleichspannungszwischenkreis angeschlossenem Photovoltaikgenerator und
- **Fig. 2**: ist ein Ablaufdiagramm zum Auswählen von zwei spannungsverschiedenen Punkten des ungeerdeten Gleichspannungszwischenkreises des Wechselrichters gemäß Fig. 1 für eine Messung eines Isolationswiderstands in dem Wechselrichter.

### FIGURENBESCHREIBUNG

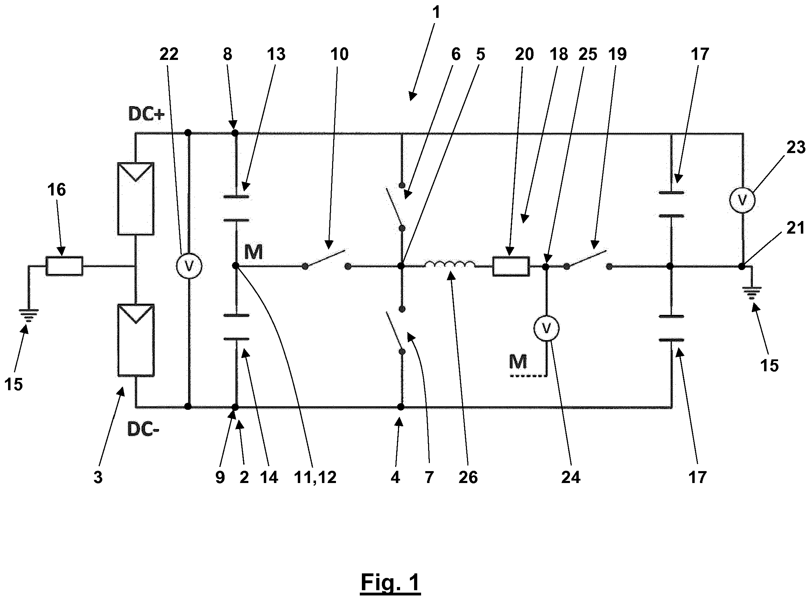

In **Fig. 1** ist ein Wechselrichter 1 gezeigt, an dessen eingangsseitigen Gleichspannungszwischenkreis 2 ein Photovoltaikgenerator 3 angeschlossen ist. Der Wechselrichter 1 weist eine an den Gleichspannungszwischenkreis 2 angeschlossene Brückenschaltung 4 auf, die als Mehrpunktschaltung, konkret als Dreipunktschaltung ausgebildet ist. Ein Brückenmittelpunkt 5 ist nicht nur mit zwei Schaltelementen 6 und 7 mit Endpunkten 8 und 9 des Gleichspannungszwischenkreises 2 verbindbar, sondern mit einem zusätzlichen Schaltelement 10 auch mit einem Zwischenspannungspunkt 11, konkret einem Spannungsmittelpunkt 12 zwischen zwei gleich großen Zwischenkreisteilkapazitäten 13 und 14 des Gleichspannungszwischenkreises 2. Von dem Photovoltaikgenerator 3 wird der Gleichspannungszwischenkreis 2 auf eine Zwischenkreisspannung aufgeladen. Bei einem Photovoltaikgenerator 3 mit weder direkt noch indirekt geerdetem Mittelpunkt kann sich eine erhebliche Spannung zwischen dem Spannungsmittelpunkt 12 und Erde 15 ausbilden, und diese Spannung kann über den Betrieb des Wechselrichters 1 hinweg stark variieren. So können die Spannungen zwischen den Endpunkten 8 und 9 des Gleichspannungszwischenkreises 2 und Erde 15 Werte erreichen, die deutlich mehr als die Hälfte der Zwischenkreisspannung betragen.

Ein Isolationswiderstand 16 des Photovoltaikgenerators 3 und des angeschlossenen Wechselrichters 1 gegenüber Erde 15 ist zumindest vor der Aufnahme des Betriebs des Photovoltaikgenerators 3 und des Wechselrichters 1 zu überprüfen. Von dem Photovoltaikgenerator 3 nach Erde 15 fließende Ströme werden auch von parasitären Kapazitäten 17 bestimmt. Zum Messen des ohmschen Isolationswiderstands 16 weist der Wechselrichter 1 eine Vorrichtung 18 auf. Die Vorrichtung 18 umfasst einen Erdschalter 19, um den Brückenmittelpunkt 5 über einen Messwiderstand 20 hinweg mit einem Erdungspunkt 21 zu verbinden. Wenn dann der Brückenmittelpunkt 5 mit einem der Schaltelemente 6, 7 oder 10 mit einem der Endpunkte 8 und 9 oder dem Spannungsmittelpunkt 12 des Gleichspannungszwischenkreises 2 verbunden wird, fließt über den Messwiderstand 20 ein Strom nach Erde 15, der, weil der Gleichspannungszwischenkreis 2 nur über den Isolationswiderstand 16 des Photovoltaikgenerators 3 elektrisch mit Erde 15 verbunden ist, bezüglich seines Gleichstromanteils durch diesen Isolationswiderstand 16 bestimmt wird. Zur vollständigen Messung des Isolationswiderstands 16 sind an dem Brückenmittelpunkt 5 mit Hilfe der Schaltelemente 6, 7, 10 mindestens zwei möglichst verschiedene Spannungen gegenüber Erde 15 anzulegen, die den Strom nach Erde 15 mit unterschiedlicher Stärke und/oder Richtung durch den Messwiderstand 20 treiben. Der Einfluss des Isolationswiderstands 16 auf den Strom nach Erde 15 hängt davon ab, wie der Isolationswiderstand 16 über den Photovoltaikgenerator 3 verteilt ist, d. h. bei welcher Spannung gegenüber Erde 15 in dem Photovoltaikgenerator 3 der Isolationswiderstand 16 seinen geringsten Wert aufweist. Unterschiedliche Spannungen, die den Strom zu dem Erdungspunkt 21 durch den Messwiderstand 20 treiben, können auch in Form einer Wechselspannung eingestellt werden, die dann aber niedrigfrequent sein sollte, damit der resultierende Wechselstrom durch den Messwiderstand 20 nicht durch die parasitären Kapazitäten 17 und 18 dominiert wird.

Zum Messen der den Strom durch den Messwiderstand 20 treibenden Spannung sind Messeinrichtungen 22 bis 24 vorgesehen. Die Messeinrichtung 22 misst die über dem Gleichspannungszwischenkreis 2 anliegende Zwischenkreisspannung. Die Messeinrichtung 23 misst die Spannung des Endpunkts 8 des Gleichspannungszwischenkreises 2 gegenüber Erde 15. Hieraus lässt sich in Verbindung mit der mit der Messeinrichtung 22 gemessenen Spannung auch die Spannung des zweiten Endpunkts 9 des Gleichspannungszwischenkreises 2 gegenüber Erde 15 bestimmen. Die Messeinrichtung 24 bestimmt die Spannung zwischen einem Punkt 25 und dem Spannungsmittelpunkt 12. Der Punkt 25 liegt zwischen dem Messwiderstand 20 und dem Erdschalter 19. Bei geschlossenem Erdschalter 19 und geschlossenem Schaltelement 10 misst die Messeinrichtung 24 die über dem Messwiderstand 20 abfallende Spannung. Bei geschlossenem Erdschalter 19 und offenem Schaltelement 10 misst die Messeinrichtung 24 die Spannung zwischen dem Spannungsmittelpunkt 12 und Erde 15. Mit Hilfe der Maschenregel lassen sich aus den mit den Messeinrichtungen 22 bis 24 gemessenen Spannungen alle weiteren interessierenden Spannungen, die gegenüber Erde 15 an bestimmten Punkten anliegen oder über dem Messwiderstand 20 abfallen, bestimmen.

Eine Drossel 26 ist Teil eines Filters in einem Ausgang des Wechselrichters 1, über den im normalen Betrieb der Brückenschaltung 4 ein Wechselstrom ausgegeben wird. Dieser Ausgang würde dann zwischen der Drossel 26 und dem Messwiderstand 20 abzweigen, was in Fig. 1 nicht dargestellt ist.

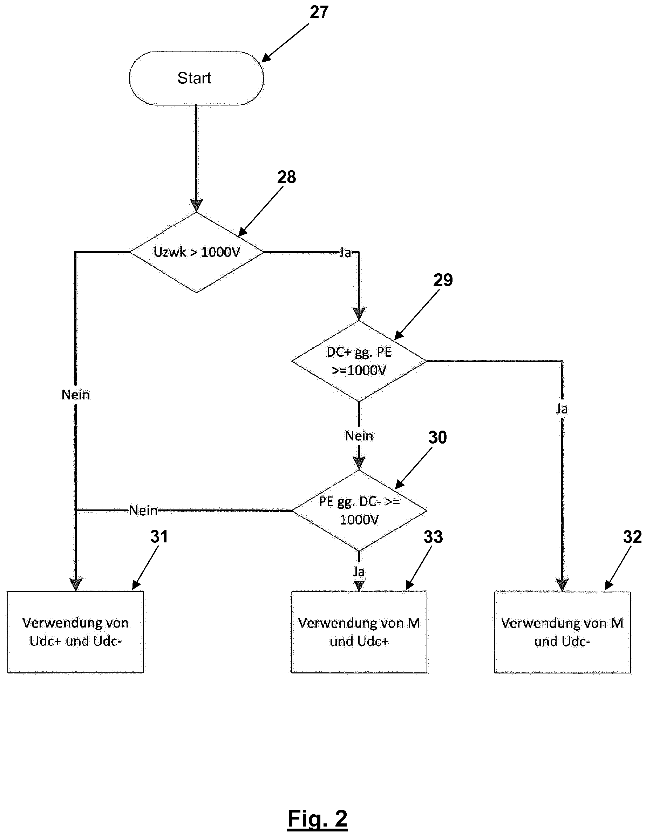

Damit die den Strom durch den Messwiderstand 20 nach Erde 15 treibenden Spannungen einen vorgegebenen Spannungsgrenzwert, für den die Bestandteile des Wechselrichters 1 ausgelegt sind, nicht überschreiten, werden zwei spannungsverschiedene Punkte des Gleichspannungszwischenkreises 2, die von der Vorrichtung 18 aufeinanderfolgend mit dem Brückenmittelpunkt 5 verbunden werden, um den Isolationswiderstand 16 zu messen, gemäß der in Fig. 2 illustrierten Vorgehensweise ausgewählt. Nach einem Start 27 des Auswählens erfolgt ein Vergleich 28 der Zwischenkreisspannung Uzwk, die mit der Messeinrichtung 22 zwischen den Endpunkten 8 und 9 des Gleichspannungszwischenkreises 2 gemessen wird, mit dem vorgegebenen Spannungsgrenzwert von hier 1.000 V. Wenn die Zwischenkreisspannung Uzwk nicht größer als 1.000 V ist, werden die beiden Pole Udc+ und Udc- des Gleichspannungszwischenkreises 2 für das Treiben des Stroms durch den Messwiderstand 20 nach Erde 15 ausgewählt 31, d. h. die Vorrichtung 18 verbindet die entsprechenden Endpunkte 8 und 9 des Gleichspannungszwischenkreises 2 mit Hilfe der Schaltelemente 6 und 7 aufeinanderfolgend mit dem Brückenmittelpunkt 5. Falls die Zwischenkreisspannung Uzwk den vorgegebenen Spannungsgrenzwert von 1.000 V überschreitet, wird in einem weiteren Vergleich 29 überprüft, ob die von der Messeinrichtung 23 gemessene Spannung DC+ gegenüber PE, d. h. zwischen dem Endpunkt 8 des Gleichspannungszwischenkreises 2 und Erde 15 größer als der oder gleich dem vorgegebenen Spannungsgrenzwert von 1.000 V ist. Falls dies der Fall ist, wird neben dem an dem zweiten Endpunkt 9 des Gleichspannungszwischenkreises 2 vorliegenden Potential des anderen Pols Udc- des Gleichspannungszwischenkreises 2 das Potential M an dem Spannungsmittelpunkt 12 für das Messen des Isolationswiderstands 16 ausgewählt 32. Falls die mit der Messeinrichtung 23 gemessene Spannung kleiner als 1.000 V ist, wird in einem Vergleich 30 geprüft, ob die Spannung PE gegenüber DC-, d. h. die Spannung zwischen Erde 15 und dem zweiten Endpunkt 9 des Gleichspannungszwischenkreises 2, größer als der oder gleich dem Spannungsgrenzwert von 1.000 V ist. Diese Spannung ergibt sich durch Subtrahieren der von der Messeinrichtung 23 gemessenen Spannung von der mit der Messeinrichtung 22 gemessenen Zwischenkreisspannung. Falls das Ergebnis des Vergleichs 30 nein ist, werden trotz der den Spannungsgrenzwert überschreitenden Zwischenkreisspannung Uzwk als Ergebnis die beiden Pole Udc+ und Udc- des Gleichspannungszwischenkreises 2 zum Treiben des Stroms durch den Messwiderstand 20 zum Messen des Isolationswiderstands 16 ausgewählt 31. Falls das Ergebnis des Vergleichs 30 jedoch positiv ist, wird neben dem Potential des positiven Pols Udc+ des Gleichspannungszwischenkreises 2 das Potential M an dem Spannungsmittelpunkt 12 gegenüber Erde zum Messen des Isolationswiderstands 16 ausgewählt 33, weil zumindest keine dieser beiden Spannungen den Spannungsgrenzwert von 1.000 V überschreitet. Insgesamt wird durch die Auswahl der spannungsverschiedenen Punkte des Gleichspannungszwischenkreises 2 für die Messung des Isolationswiderstands gemäß Fig. 2 erreicht, dass sich die beiden ausgewählten spannungsverschiedenen Punkte möglichst weit in ihrer Spannung gegenüber Erde 15 unterscheiden und in der Regel auch unterschiedliche Vorzeichen dieser Spannung aufweisen, ohne dass jedoch eine dieser Spannungen den Spannungsgrenzwert überschreitet.

### BEZUGSZEICHENLISTE

- 1: Wechselrichter
- 2: Gleichspannungszwischenkreis
- 3: Photovoltaikgenerator
- 4: Brückenschaltung
- 5: Brückenmittelpunkt
- 6: Schaltelement
- 7: Schaltelement
- 8: (erster) Endpunkt des Gleichspannungszwischenkreises 2
- 9: (zweiter) Endpunkt des Gleichspannungszwischenkreises 2
- 10: Schaltelement
- 11: Zwischenspannungspunkt
- 12: Spannungsmittelpunkt
- 13, 14: Zwischenkreisteilkapazität
- 15: Erde
- 16: Isolationswiderstand
- 17: parasitäre Kapazität
- 18: Vorrichtung
- 19: Erdschalter
- 20: Messwiderstand
- 21: Erdungspunkt
- 22-24: Messeinrichtung
- 25: Punkt
- 26: Drossel
- 27: Start
- 28-30: Vergleich
- 31- 33: Auswahl

## Patentansprüche

1. Verfahren zur Isolationswiderstandsmessung in einem Wechselrichter (1), der einen Gleichspannungszwischenkreis (2) und eine an den Gleichspannungszwischenkreis (2) angeschlossene Brückenschaltung (4) zum Treiben eines Wechselstroms über einen Brückenmittelpunkt (5) aufweist, mit den Schritten
- Verbinden des Brückenmittelpunkts (5) mit einem Erdungspunkt (21),
- Verbinden des mit dem Erdungspunkt (21) verbundenen Brückenmittelpunkts (5) mittels der Brückenschaltung (4) nacheinander mit zwei spannungsverschiedenen Punkten des ungeerdeten Gleichspannungszwischenkreises (2) und
- Messen des von den beiden spannungsverschiedenen Punkten zu dem Erdungspunkt (21) fließenden Stroms,
**gekennzeichnet durch** ein Auswählen der beiden spannungsverschiedenen Punkte des ungeerdeten Gleichspannungszwischenkreises (2) aus einer Gruppe von Punkten, die neben zwei Endpunkten (8, 9) des Gleichspannungszwischenkreises (2) mindestens einen Zwischenspannungspunkt (11) des Gleichspannungszwischenkreises (2) umfasst, derart, dass die zwischen den beiden spannungsverschiedenen Punkten und Erde (15) anliegenden elektrischen Spannungen einen vorgegebenen Spannungsgrenzwert nicht überschreiten.

2. Verfahren nach Anspruch 1, **dadurch gekennzeichnet, dass** das Auswählen der beiden spannungsverschiedenen Punkte des ungeerdeten Gleichspannungszwischenkreises (2) eine Prüfung umfasst, ob eine der beiden zwischen den beiden Endpunkten (8, 9) des Gleichspannungszwischenkreises (2) und Erde (15) anliegenden Spannungen den vorgegebenen Spannungsgrenzwert überschreitet, und dass dann, wenn dies der Fall ist, der Endpunkt (8, 9) des Gleichspannungszwischenkreises (2), bei dem die Spannung den vorgegebenen Spannungsgrenzwert nicht überschreitet, und der Zwischenspannungspunkt (11) des Gleichspannungszwischenkreises (2) ausgewählt werden..

3. Verfahren nach Anspruch 2, **dadurch gekennzeichnet, dass** die Prüfung eine erste Prüfung umfasst, in der geprüft wird, ob die zwischen einem ersten der beiden Endpunkte (8) des Gleichspannungszwischenkreises (2) und Erde (15) anliegende Spannung den vorgegebenen Spannungsgrenzwert überschreitet, und dass die Prüfung eine zweite Prüfung umfasst, in der geprüft wird, ob die zwischen dem zweiten der beiden Endpunkte (9) des Gleichspannungszwischenkreises (2) und Erde (15) anliegende Spannung den vorgegebenen Spannungsgrenzwert überschreitet, und dass basierend auf einem ersten Ergebnis der ersten Prüfung und einem zweiten Ergebnis der zweiten Prüfung mit Hilfe einer Wahrheitstabelle festgelegt wird, welche beiden spannungsverschiedenen Punkte des ungeerdeten Gleichspannungszwischenkreises (2) aus der Gruppe von Punkten ausgewählt werden.

4. Verfahren nach Anspruch 2, **dadurch gekennzeichnet, dass** ein erster Teilschritt des Auswählens der beiden spannungsverschiedenen Punkte des ungeerdeten Gleichspannungszwischenkreises (2) eine dritte Prüfung umfasst, in der geprüft wird, ob eine zwischen den beiden Endpunkten (8, 9) des Gleichspannungszwischenkreises (2) anliegende Zwischenkreisspannung den vorgegebenen Spannungsgrenzwert überschreitet, und dass dann, wenn dies nicht der Fall ist, die beiden Endpunkte (8, 9) des Gleichspannungszwischenkreises (2) ausgewählt werden.

5. Verfahren nach Anspruch 4, **dadurch gekennzeichnet, dass** ein zweiter Teilschritt des Auswählens der beiden spannungsverschiedenen Punkte des ungeerdeten Gleichspannungszwischenkreises (2), wenn die Zwischenkreisspannung den vorgegebenen Spannungsgrenzwert überschreitet, eine vierte Prüfung umfasst, in der überprüft wird, ob die zwischen einem ersten der beiden Endpunkte (8) des Gleichspannungszwischenkreises (2) und Erde (15) anliegende Spannung den vorgegebenen Spannungsgrenzwert überschreitet, und dass dann, wenn dies der Fall ist, der zweite der beiden Endpunkte (9) und der mindestens eine Zwischenspannungspunkt (11) des Gleichspannungszwischenkreises (2) ausgewählt werden.

6. Verfahren nach Anspruch 5, **dadurch gekennzeichnet, dass** ein dritter Teilschritt des Auswählens der beiden spannungsverschiedenen Punkte des ungeerdeten Gleichspannungszwischenkreises (2), wenn die zwischen dem ersten der beiden Endpunkte (8) des Gleichspannungszwischenkreises (2) und Erde (15) anliegende Spannung den vorgegebenen Spannungsgrenzwert nicht überschreitet, eine fünfte Prüfung umfasst, in der überprüft wird, ob die zwischen dem zweiten der beiden Endpunkte (9) des Gleichspannungszwischenkreises (2) und Erde (15) anliegende Spannung den vorgegebenen Spannungsgrenzwert überschreitet, und dass dann, wenn dies der Fall ist, der erste der beiden Endpunkte (8) und der mindestens eine Zwischenspannungspunkt (11) des Gleichspannungszwischenkreises (2) ausgewählt werden, während dann, wenn dies nicht der Fall ist, die beiden Endpunkte (8, 9) des Gleichspannungszwischenkreises (2) ausgewählt werden.

7. Verfahren nach einem der vorhergehenden Ansprüche, **dadurch gekennzeichnet, dass** der mindestens eine Zwischenspannungspunkt (11) ein Spannungsmittelpunkt (12) des Gleichspannungszwischenkreises (2) ist.

8. Verfahren nach einem der vorhergehenden Ansprüche, **dadurch gekennzeichnet, dass** der vorgegebenen Spannungsgrenzwert zwischen 800 und 1.500 V oder zwischen 900 und 1.200 V liegt.

9. Wechselrichter (1) mit
- einem Gleichspannungszwischenkreis (2),
- einer an den Gleichspannungszwischenkreis (2) angeschlossenen Brückenschaltung (4) zum Treiben eines Wechselstroms über einen Brückenmittelpunkt (5) und
- einer Vorrichtung (18) zum Messen eines Isolationswiderstands (16), die einen Erdschalter (19) aufweist, mit welchem der Brückenmittelpunkt (5) mit einem Erdungspunkt (21) verbindbar ist, und die dazu ausgebildet ist, den mit dem Erdungspunkt (21) verbundenen Brückenmittelpunkt (5) mittels der Brückenschaltung (4) nacheinander mit zwei spannungsverschiedenen Punkten des ungeerdeten Gleichspannungszwischenkreises (2) zu verbinden und den von den beiden spannungsverschiedenen Punkten zu dem Erdungspunkt (21) fließenden Strom zu messen,
**dadurch gekennzeichnet,**
- **dass** die Brückenschaltung (4) eine Mehrpunktschaltung ist, die dazu ausgebildet ist, den Brückenmittelpunkt (5) beim Treiben des Wechselstroms neben zwei Endpunkten (8, 9) des Gleichspannungszwischenkreises (2) auch mit mindestens einem Zwischenspannungspunkt (11) des Gleichspannungszwischenkreises (2) zu verbinden, und
- **dass** die Vorrichtung (18) zur Durchführung des Verfahrens nach einem der vorhergehenden Ansprüche ausgebildet ist.

10. Wechselrichter (1) nach Anspruch 9, **dadurch gekennzeichnet, dass** die Brückenschaltung (4) eine Dreipunktschaltung ist, die dazu ausgebildet ist, den Brückenmittelpunkt (5) beim Treiben des Wechselstroms neben den beiden Endpunkten (8, 9) auch mit einem Spannungsmittelpunkt (12) als dem mindestens einen Zwischenspannungspunkt (11) des Gleichspannungszwischenkreises (2) zu verbinden.

11. Wechselrichter (1) nach Anspruch 9 oder 10, **dadurch gekennzeichnet, dass** eine nominelle Spannungsfestigkeit von Schaltelementen (6, 7) der Brückenschaltung (4) und/oder von Bestandteilen der Vorrichtung (18), die speziell zum Messen des Isolationswiderstands (16) vorgesehen sind, gleich dem vorgegebenen Spannungsgrenzwert ist.

## Claims

1. A method for measuring insulation resistance in an inverter (1) that has a DC link circuit (2) and a bridge circuit (4), connected to the DC link circuit (2), for driving an AC current via a bridge center tap (5), having the steps of
- connecting the bridge center tap (5) to a grounding point (21),
- successively connecting, by way of the bridge circuit (4), the bridge center tap (5) connected to the grounding point (21) to two points of the ungrounded DC link circuit (2) that differ in terms of voltage and
- measuring the current flowing from the two points that differ in terms of voltage to the grounding point (21),
**characterized by** a selection of the two points of the ungrounded DC link circuit (2) that differ in terms of voltage are selected from a group of points that comprises at least one intermediate voltage point (11) of the DC link circuit (2) in addition to two end points (8, 9) of the DC link circuit (2), such that the voltages present between the two points that differ in terms of voltage and ground (15) do not exceed a predefined voltage limit value.

2. The method as claimed in claim 1, **characterized in that** the selection of the two points of the ungrounded DC link circuit (2) that differ in terms of voltage comprises a test whether one of the two voltages present between the two end points (8, 9) of the DC link circuit (2) and ground (15) exceeds the predefined voltage limit value, and **in that**, if this is the case, the end point (8, 9) of the DC link circuit (2) at which the voltage does not exceed the predefined voltage limit value and the intermediate voltage point (11) of the DC link circuit (2) are selected.

3. The method as claimed in claim 2, **characterized in that** the test comprises a first test, in which it is checked whether the voltage present between a first of the two end points (8) of the DC link circuit (2) and ground (15) exceeds the predefined voltage limit value, and that the test comprises a second test, in which it is checked whether the voltage present between the second of the two end points (9) of the DC link circuit (2) and ground (15) exceeds the predefined voltage limit value, and **in that**, based on a first result of the first test and a second result of the second test, a truth table is used to determine which two points of the ungrounded DC link circuit (2) that differ in terms of voltage are selected from the group of points.

4. The method as claimed in claim 2, **characterized in that** a first sub-step of the selection of the two points of the ungrounded DC link circuit (2) that differ in terms of voltage comprises a third test, in which it is checked whether a link circuit voltage present between the two end points (8, 9) of the DC link circuit (2) exceeds the predefined voltage limit value, and **in that**, if this is not the case, the two end points (8, 9) of the DC link circuit (2) are selected.

5. The method as claimed in claim 4, **characterized in that** a second sub-step of the selection of the two points of the ungrounded DC link circuit (2) that differ in terms of voltage, when the link circuit voltage exceeds the predefined voltage limit value comprises a fourth test, in which it is checked whether the voltage present between a first of the two end points (8) of the DC link circuit (2) and ground (15) exceeds the predefined voltage limit value, and **in that**, if this is the case, the second of the two end points (9) and the at least one intermediate voltage point (11) of the DC link circuit (2) are selected.

6. The method as claimed in claim 5, **characterized in that** a third sub-step of the selection of the two points of the ungrounded DC link circuit (2) that differ in terms of voltage, when the voltage present between the first of the two end points (8) of the DC link circuit (2) and ground (15) does not exceed the predefined voltage limit value comprises a fifth test, in which it is checked whether the voltage present between the second of the two end points (9) of the DC link circuit (2) and ground (15) exceeds the predefined voltage limit value, and **in that**, if this is the case, the first of the two end points (8) and the at least one intermediate voltage point (11) of the DC link circuit (2) are selected, whereas, if this is not the case, the two end points (8, 9) of the DC link circuit (2) are selected.

7. The method as claimed in one of the preceding claims, **characterized in that** the at least one intermediate voltage point (11) is a voltage center tap (12) of the DC link circuit (2).

8. The method as claimed in one of the preceding claims, **characterized in that** the predefined voltage limit value is between 800 and 1500 V or between 900 and 1200 V.

9. An inverter (1) having
- a DC link circuit (2),
- a bridge circuit (4), connected to the DC link circuit (2), for driving an AC current through a bridge center tap (5) and
- a device (18) for measuring an insulation resistance (16) that has a grounding switch (19) by way of which the bridge center tap (5) is able to be connected to a grounding point (21) and that is designed to successively connect, by way of the bridge circuit (4), the bridge center tap (5) connected to the grounding point (21) to two points of the ungrounded DC link circuit (2) that differ in terms of voltage and to measure the current flowing from the two points that differ in terms of voltage to the grounding point (21),
**characterized**
- **in that** the bridge circuit (4) is a multi-level circuit that is designed, when driving the AC current, to also connect the bridge center tap (5) to at least one intermediate voltage point (11) of the DC link circuit (2) in addition to two end points (8, 9) of the DC link circuit (2), and
- **in that** the device (18) is designed to perform the method as claimed in one of the preceding claims.

10. The inverter (1) as claimed in claim 9, **characterized in that** the bridge circuit (4) is a three-level circuit that is designed, when driving the AC current, to also connect the bridge center tap (5) to a voltage center tap (12) as the at least one intermediate voltage point (11) of the DC link circuit (2) in addition to the two end points (8, 9).

11. The inverter (1) as claimed in claim 9 or 10, **characterized in that** a nominal voltage rating of switching elements (6, 7) of the bridge circuit (4) and/or of components of the device (18) that are specifically provided for measuring the insulation resistance (16) is equal to the predefined voltage limit value.

## Revendications

1. Procédé de mesure de la résistance d'isolement dans un onduleur (1) qui possède un circuit de liaison CC (2) et un circuit de pont (4), connecté au circuit de liaison CC (2), pour conduire un courant CA via un point central de pont (5), comportant les étapes suivantes
- connecter le point central du pont (5) à un point de mise à la terre (21),
- connecter successivement, au moyen du circuit de pont (4), le point central de pont (5) connectée au point de mise à la terre (21) à deux points du circuit de liaison CC non mis à la terre (2) qui diffèrent en termes de tension, et
- la mesure du courant circulant depuis les deux points qui diffèrent en termes de tension jusqu'au point de mise à la terre (21),
**caractérisé par le fait que** les deux points du circuit de liaison CC non mis à la terre (2) qui diffèrent en termes de tension sont sélectionnés dans un groupe de points qui comprend au moins un point de tension intermédiaire (11) du circuit de liaison CC (2) en plus des deux points d'extrémité (8, 9) du circuit de liaison CC (2), de sorte que les tensions présentes entre les deux points qui diffèrent en termes de tension et la terre (15) ne dépassent pas une valeur limite de tension prédéfinie.

2. Procédé selon la revendication 1, **caractérisé en ce que** la sélection des deux points du circuit de liaison CC non mis à la terre (2) qui diffèrent en termes de tension comprend un test pour savoir si l'une des deux tensions présentes entre les deux points d'extrémité (8, 9) du circuit de liaison CC (2) et la terre (15) dépasse la valeur limite de tension prédéfinie, et **en ce que**, si tel est le cas, le point d'extrémité (8, 9) du circuit de liaison CC (2) auquel la tension ne dépasse pas la valeur limite de tension prédéfinie et le point de tension intermédiaire (11) du circuit de liaison CC (2) sont sélectionnés.

3. Procédé selon la revendication 2, **caractérisé en ce que** le test comprend un premier test, dans lequel on vérifie si la tension présente entre un premier des deux points d'extrémité (8) du circuit de liaison CC (2) et la terre (15) dépasse la valeur limite de tension prédéfinie, et **en ce que** le test comprend un second test, dans lequel on vérifie si la tension présente entre le second des deux points d'extrémité (9) du circuit de liaison CC (2) et la terre (15) dépasse la valeur limite de tension prédéfinie, et dans lequel, sur la base d'un premier résultat du premier test et d'un second résultat du second test, une table de vérité est utilisée pour déterminer quels sont les deux points du circuit de liaison CC non mis à la terre (2) qui diffèrent en termes de tension et qui sont sélectionnés dans le groupe de points.

4. Procédé selon la revendication 2, **caractérisé en ce qu'**une première sous-étape de la sélection des deux points du circuit de liaison CC non mis à la terre (2) qui diffèrent en termes de tension comprend un troisième test, dans lequel on vérifie si une tension du circuit de liaison présente entre les deux points d'extrémité (8, 9) du circuit de liaison CC (2) dépasse la valeur limite de tension prédéfinie, et **en ce que**, si ce n'est pas le cas, les deux points d'extrémité (8, 9) du circuit de liaison CC (2) sont sélectionnés.

5. Procédé selon la revendication 4, **caractérisé en ce qu'**une deuxième sous-étape de la sélection des deux points du circuit de liaison CC non mis à la terre (2) qui diffèrent en termes de tension, lorsque la tension du circuit de liaison dépasse la valeur limite de tension prédéfinie, comprend un quatrième test, dans lequel on vérifie si la tension présente entre un premier des deux points d'extrémité (8) du circuit de liaison CC (2) et la terre (15) dépasse la valeur limite de tension prédéfinie, et dans lequel, si tel est le cas, le second des deux points d'extrémité (9) et le au moins un point de tension intermédiaire (11) du circuit de liaison CC (2) sont sélectionnés.

6. Procédé selon la revendication 5, **caractérisé en ce qu'**une troisième sous-étape de la sélection des deux points du circuit de liaison CC non mis à la terre (2) qui diffèrent en termes de tension, lorsque la tension présente entre le premier des deux points d'extrémité (8) du circuit de liaison CC (2) et la terre (15) ne dépasse pas la valeur limite de tension prédéfinie, comprend un cinquième test, dans lequel on vérifie si la tension présente entre le second des deux points d'extrémité (9) du circuit de liaison CC (2) et la terre (15) dépasse la valeur limite de tension prédéfinie, et dans lequel, si tel est le cas, le premier des deux points d'extrémité (8) et le au moins un point de tension intermédiaire (11) du circuit de liaison CC (2) sont sélectionnés, tandis que, si tel n'est pas le cas, les deux points d'extrémité (8, 9) du circuit de liaison CC (2) sont sélectionnés.

7. Procédé selon l'une des revendications précédentes, **caractérisé en ce que** le au moins un point de tension intermédiaire (11) est un point central de tension (12) du circuit de liaison CC (2).

8. Procédé selon l'une des revendications précédentes, **caractérisé en ce que** la valeur limite de tension prédéfinie est comprise entre 800 et 1500 V ou entre 900 et 1200 V.

9. Onduleur (1) comportant
- un circuit de liaison CC (2)
- un circuit de pont (4), connecté au circuit de liaison CC (2), pour conduire un courant alternatif à travers un point central de pont (5) et
- un dispositif (18) pour mesurer une résistance d'isolement (16) qui comporte un interrupteur de mise à la terre (19) au moyen duquel le point central du pont (5) peut être connectée à un point de mise à la terre (21) et qui est conçu pour connecter successivement, au moyen du circuit de pont (4), le point central du pont (5) connectée au point de mise à la terre (21) à deux points du circuit de liaison CC non mis à la terre (2) qui diffèrent en termes de tension et pour mesurer le courant circulant à partir des deux points qui diffèrent en termes de tension jusqu'au point de mise à la terre (21),
**caractérisé**
- **en ce que** le circuit de pont (4) est un circuit à plusieurs niveaux conçu, lorsqu'il conduit le courant alternatif, pour connecter également le point central du pont (5) à au moins un point de tension intermédiaire (11) du circuit de liaison CC (2) en plus des deux points d'extrémité (8, 9) du circuit de liaison CC (2), et
- **en ce que** le dispositif (18) est conçu pour mettre en oeuvre la méthode telle que revendiquée dans l'une des revendications précédentes.

10. Onduleur (1) selon la revendication 9, **caractérisé en ce que** le circuit de pont (4) est un circuit à trois niveaux qui est conçu, lorsqu'il conduit le courant alternatif, pour connecter également le point central de pont (5) à un point central de tension (12) en tant qu'au moins un point de tension intermédiaire (11) du circuit de liaison CC (2) en plus des deux points d'extrémité (8, 9).

11. Onduleur (1) selon la revendication 9 ou 10, **caractérisé par le fait qu'**une tension nominale des éléments de commutation (6, 7) du circuit de pont (4) et/ou des composants du dispositif (18) qui sont spécifiquement prévus pour mesurer la résistance d'isolement (16) est égale à la valeur limite de tension prédéfinie.
